# FASCICULE DE BREVET EUROPEEN

(11) **EP 1 576 658 B1**
(45) Date de publication et mention de la délivrance du brevet: **21.01.2009**
(21) Numéro de dépôt: 03799685.7
(22) Date de dépôt: 22.12.2003
(51) Int. Cl.: H01L 21/18, H01L 21/762

(54) **PROCEDE DE REALISATION DE SUBSTRATS MIXTES ET STRUCTURE AINSI OBTENUE**
HERSTELLUNGSVERFAHREN FÜR GEMISCHTE SUBSTRATE UND DADURCH HERGESTELLTE STRUKTUR
METHOD OF PRODUCING MIXED SUBSTRATES AND STRUCTURE THUS OBTAINED

(30) Priorité: 24.12.2002 FR 0216646
(43) Date de publication de la demande: 21.09.2005
(73) Titulaire: COMMISSARIAT A L'ENERGIE ATOMIQUE, 75015 Paris (FR)
(72) Inventeur: FOURNEL, Franck, 38190 Villard-Bonnot (FR); MORICEAU, Hubert, F-38120 Saint-Egreve (FR); ASPAR, Bernard, F-38140 Rives (FR); ZUSSY, Marc, 38120 Saint Egreve (FR)
(74) Mandataire: Quantin, Bruno Marie Henri
(86) Numéro de dépôt international: PCT/FR2003/003867
(87) Numéro de publication internationale: WO 2004/059711

(56) Documents cités:
- EP-A- 0 889 509
- FR-A- 2 819 099
- US-A- 4 920 396
- US-A- 5 138 422
- US-A- 5 661 316
- US-A- 6 013 954
- US-A1- 2001 007 367

## Description

L'invention concerne un procédé de réalisation de substrats mixtes, c'est à dire des substrats dans lesquels on peut réaliser à la fois des composants microélectroniques avec couche enterrée, et des composants sans couche enterrée ; cette couche enterrée peut être isolante, mais il peut aussi s'agir de réaliser des composants optiques (par exemple du type MOEMS) ou un microsystème sur des substrats présentant à la fois des parties massives et des parties pourvues d'une couche enterrée (par partie massive, on entend une partie présentant une continuité, cristalline et/oui électrique...).

Les composants électroniques sont généralement réalisés sur des plaquettes de matériaux semi-conducteurs, comme par exemple le silicium.

Plusieurs types de composants électroniques existent, correspondant à plusieurs types d'applications, par exemple les composants de puissance d'une part, et les composants de logique ou de commande, d'autre part. Ces composants peuvent être réalisés sur des plaquettes différentes, par exemple des plaquettes massives, d'une part, et des plaquettes à couche isolante enterrée, d'autre part ; ces dernières sont parfois appelées « SOI » (sigle anglais pour Silicon On Isolator lorsque leur matériau constitutif est le silicium).

Les plaquettes « massives » (ou « bulk » en anglais) ont notamment pour intérêt de permettre de réaliser des composants dits verticaux, c'est à dire qu'ils permettent une conduction électrique entre les faces avant et arrière de la plaquette. Par contre, les plaquettes de type SOI permettent de réaliser des composants totalement isolés les uns des autres et isolés de leur substrat ; ce type de plaquette est également très utilisé pour la réalisation de composants MEMS ou MOEMS.

Dans ce qui suit, le seul exemple du matériau constitutif des plaquettes sera le silicium et le seul exemple de couche enterrée sera l'oxyde considéré (donc une couche isolante), mais il devra être compris que d'autres matériaux, en pratique semi-conducteurs, sont possibles, notamment InP, AsGa, Ge, SiₓGe₁₋ₓ, LiNbO₃, les composés III-V, les composés II-VI, SiC, le diamant, le saphir, ainsi que les matériaux piezoélectriques et pyroélectriques, et que d'autres couches enterrées sont possibles.

Par ailleurs, le terme de plaquette massive ou de type « bulk », qui dans les exemples qui suivent désignera une plaquette en un seul matériau, devra être compris comme pouvant désigner plus généralement une plaquette en un ou plusieurs matériaux sans couche enterrée (a fortiori sans couche enterrée isolante), par exemple un substrat en silicium sous une couche de germanium.

II peut être noté que l'utilisation de plaquettes SOI, dont la réalisation est bien maîtrisée, peut être intéressante même lorsqu'il n'est pas nécessaire que la couche enterrée soit isolante.

II devient important d'intégrer des composants différents dans un faible volume afin d'obtenir des fonctions avancées. Pour de nombreuses applications, l'association de composants réalisés sur un matériau de type bulk avec des composants réalisés sur un matériau de type SOI présente de nombreux avantages, puisqu'elle permet notamment de réaliser des composants de puissance avec leurs circuits logiques, ou avec des capteurs, etc...

Un des moyens d'associer ces différents types de composants est de les réaliser sur une même plaquette, ce qui est possible en utilisant des plaquettes en partie constituées de zones de type bulk et en partie de zones de type SOI.

De telles plaquettes mixtes ou substrats mixtes présentent de nombreux avantages, dont les suivants :
* elle permettent de réaliser à la fois des composants qui sont totalement isolés les uns des autres et des composants qui fonctionnent verticalement, c'est à dire qu'une conduction électrique est permise à travers le volume de certaines zones de la plaquette,
* elles permettent de réaliser sur une même plaquette différents types de fonction : électrique et/ou mécanique et/ou optique, de façons indépendantes.

Différents procédés de fabrication de tels substrats mixtes sont notamment décrits dans les documents suivants :
- le document US - 6 096 433 (NEC Corp) qui vise à échapper aux inconvénients d'une solution antérieure selon laquelle un substrat lamifié (c'est à dire avec un empilement de couches) est fabriqué à partir de deux plaquettes semi-conductrices fixées l'une à l'autre, dont l'une présente en surface de place en place des zones isolantes (oxydes). Pour éviter l'apparition de vides à l'interface entre les deux faces (qui sont dus à la différence d'état de surface entre les zones Si et Si02 et aux marches entre les deux matériaux), il est proposé par ce document de mettre la face libre de l'oxyde en retrait vis-à-vis de la face libre environnante de Si, de sorte qu'il y a une très bonne adhésion entre les deux plaquettes (dans des zones Si et Si).
- l'article « A new DRAM cell with a transistor on a lateral epitaxial silicon layer (TOLE cell) » de K. TERADA, T. ISHIJIMA, T. KUBOTA, et M. SAKAO, paru dans IEEE-Transactions-on-Electron-Device, Vol. 37, N09, Sept. 1990, pp. 2052-7, qui propose la réalisation d'un SOI mixte par épitaxie latérale de silicium.
- l'article « Intelligent Power IC with partial SOI Structure » de H. YAMAGUCHI, H. HIMI, S. FUJINO, et T. HATTORI publié dans Jpn, J. Appl. Phys, Vol. 34 (1995), pp. 864-868, qui propose de graver l'une des faces des plaquettes devant former le futur ensemble, de coller les deux faces puis de remplir d'oxyde les cavités ainsi formées à l'interface.

Tous ces procédés utilisent le collage moléculaire avec des zones de jonction Si/Si.

En pratique ces interfaces Si/Si ne doivent idéalement induire aucune perturbation dans les futurs composants qui utiliseront ces jonctions. En particulier il est apparu important de pouvoir minimiser, dans les zones "massives", les impuretés, en particulier les précipités d'oxydes, qui sont notamment des pièges de charges pouvant perturber une bonne conduction électrique entre les deux plaquettes, ainsi que le taux de dislocations dues au désalignement entre les deux cristaux de silicium qui gêne entre autres la conduction verticale. Or ces documents n'enseignent nullement comment garantir une bonne qualité à cet interface.

Un autre type de procédé est décrit dans l'article « The Fabrication of a Partial SOI Substrate » de D.M.GARNER, G. ENSELL, J. BONAR, A. BLACKBURN, F. UDREA, H.T. LIM, A. POPESCU, P.L.F. HEMMENT et W.I. MILNE, Proceedings of the 9th International Symposium on Silicon On Isolator Technology and Devices, 1999, Vol. 99, Ch. 54, pp. 73-78, qui propose de créer une couche isolante enterrée ayant un motif prédéterminé, avec des fenêtres remplies de silicium; mais il ne s'agit pas d'un substrat mixte obtenu par collage moléculaire puisqu'il est recommandé de partir d'une plaquette de type SIMOX (de préférence à deux plaquettes collées l'une à l'autre) qui fait l'objet d'attaques localisées au travers du silicium jusqu'au travers de la couche d'oxyde isolant ; puis on fait croître par épitaxie du silicium dans les fenêtres ainsi réalisées ; il n'y a aucun interface réalisé par collage moléculaire ; ce document n'apporte donc aucune solution au problème précité de réalisation d'un interface de bonne qualité.

Un autre type de procédé est décrit dans le document US 5138422. Ce document concerne une procédé de fabrication d'un dispositif semi-conducteur qui comporte de multiples segments semi-conducteurs isolés sur une plaquette.

L'invention a pour objet un procédé de fabrication d'un substrat mixte au sens défini ci-dessus qui garantisse l'obtention d'un interface de bonne qualité, au moins électrique dans le cas de composants microélectroniques, dans les zones de type massif (ou « bulk »), notamment de type Si/Si.

L'invention a aussi pour objet un substrat mixte , ou une structure, ayant un tel interface de bonne qualité.

Elle propose à cet effet un procédé de fabrication d'un substrat mixte selon lequel :
* on prépare deux substrats présentant des faces respectives destinées à être liées l'une à l'autre et constitués essentiellement au niveau de ces faces de parties cristallines et, pour au moins l'une de ces deux faces, de zones formées d'un matériau différent de ceux constitutifs des parties cristallines,
* on met ces faces en regard et on les relie au niveau d'un interface par collage moléculaire en sorte de former des zones massives dans lesquelles les faces en regard sont essentiellement cristallines et des zones empilées dans lesquelles l'une au moins des faces en regard est essentiellement constituée du matériau différent,
* on effectue un traitement thermique de consolidation du collage,
caractérisé en ce que, lors de la préparation des substrats ou lors de la liaison des faces, on crée audit interface des pièges à impuretés tels que toute portion de cet interface faisant partie d'une zone massive soit à au plus une distance donnée d'un tel piège, tandis que la mise en regard des faces se fait avec un écart en désalignement, entre les parties cristallines de ces deux substrats, inférieur à un seuil donné.

II peut s'agir de deux cristaux, par exemple réalisés chacun en un matériau semi-conducteur, avantageusement obtenus à partir d'un même cristal d'origine (voir ci-dessous).

De manière préférée, les pièges sont des couches enterrées, telles que des couches d'oxyde localisées, et les zones formées d'un matériau différent sont des zones électriquement isolantes, ou des couches d'oxyde localisées.

II peut être noté que les parties cristallines affleurent ou, au moins sont très proches des faces (il peut en effet y avoir une couche d'oxyde natif pouvant atteindre de l'ordre de 2 nm).

Les zones empilées sont souvent des zones isolées.

On notera que, par simplification, on pourra parler de zone massive pour désigner la zone où se situera la future zone massive, en particulier, même si le contact cristallin n'est pas encore réalisé.

Ainsi l'invention propose de respecter un bon alignement des orientations cristallines entre les deux parties cristallines reliées et de distribuer des pièges à l'intérieur (ou à proximité) des zones « bulk » de façon à avoir un interface Si/Si (lorsque les deux substrats, ou plaquettes, sont en silicium) qui est compatible avec la réalisation de composants dans cette zone « bulk ». Ces pièges servent à absorber les différentes impuretés présentes sur les surfaces des faces reliées, comme notamment les précipités d'oxyde générés lors du processus de collage moléculaire.

A cet effet, un autre objet de l'invention est un procédé de réalisation d'un substrat mixte formé de l'assemblage de deux substrats comportant des parties cristallines d'une manière garantissant un très bon alignement cristallographique de ces parties cristallines au moment de leur assemblage, par collage moléculaire ou par tout autre mode de liaison pouvant bénéficier d'une bonne continuité cristallographique.

En fait, il est connu d'après le document US - 5 661 316 (HEWLETT-PACKARD Company) de chercher à minimiser les désorientations cristallines entre deux cristaux reliés par un collage de type hydrophobe en vue de réaliser un bon interface ohmique, mais il n'est nullement prévu de réaliser dans ces cristaux des zones isolées ou des pièges (ce sont nécessairement des défauts à cet interface). Des commentaires similaires s'appliquent à l'article « Charged Defects at the Interface between Directly Bonded Silicon Wafers » de A. LAPORTE, G. SARRABAYROUSE, M. BENAMARA, A. CLAVERIE, A. ROCHER et A. PEYRE-LAVIGNE. Ces documents concernent plus particulièrement le collage Si/Si de type hydrophobe.

Il est également connu que, lors d'un collage hydrophile, si les deux substrats de silicium sont collés avec, à leur surface, une couche très fine d'oxyde natif (<2 nm), et si les cristaux sont suffisamment bien alignés (<1° en rotation et <1° en flexion), le film d'oxyde peut disparaître pendant le traitement thermique de stabilisation du collage (cf "Growth, Shrinkage, and Stability of Interfacial Oxide Layers between Directly Bonded Silicon Wafers de K.Y. AHN, R. STENGL, T. Y. TAN, U. GOSELE et P. SMITH publié dans Applied Physics A, 50, 1990, pp. 85-94). Cependant il n'est pas enseigné dans cet article comment, avec un collage hydrophile de deux couches d'oxyde natif, on peut obtenir un interface sans précipité d'oxyde de silicium. En tout état de cause, ce document ne se préoccupe pas d'un substrat mixte avec un interface comportant de manière bien définie une couche d'oxyde dans certaines zones et aucune couche d'oxyde en d'autres zones.

Il est enfin connu que, lors d'un traitement thermique, en dessous d'un certain rayon critique qui dépend du budget thermique, les petits précipités d'oxyde se dissolvent au profit des plus gros au sein du silicium massif (cf "On Oxygen Precipitation Retardation/Recovery Phenomena, Nucleation Incubation Phenomena, and the Exigent-Accomodation-Volume factor of precipitation" de T.Y.TAN, C.Y. KUNG, Proceedings of the Fifth International Symposium on Silicon Materials Science and Technology ; Semiconductor Silicon 198 Electrochem, Soc, Pennington, NJ, USA ; 1986, pp. 864-73). Mais aucun enseignement n'en est tiré pour la réalisation d'un interface devant comporter de manière bien définie une couche enterrée, notamment d'oxyde, en certaines zones seulement.

Les pièges que l'invention préconise de prévoir peuvent être des zones d'oxyde enfermées au moment du collage moléculaire lors de la fabrication du substrat mixte.

Avantageusement, ces pièges peuvent être les zones en matériau différent, par exemple les zones d'oxyde définissant des zones isolées de type SOI, lorsque ces zones sont distribuées dans les plaquettes en sorte d'être peu éloignées des diverses portions des zones massives (cela dépend de la configuration choisie pour les zones massives ou isolées) pour pouvoir servir de pièges et permettre l'obtention d'un collage Si/Si sans précipités ou impuretés à l'interface de collage.

La distance donnée maximale entre une portion quelconque des zones massives et un piège, et donc l'espacement maximum entre les pièges, est fonction du type de préparation de la surface de chacune des faces, de la température des traitements thermiques de stabilisation du collage moléculaire, et du désalignement cristallin entre les deux parties cristallines.

Dans le cas d'un collage hydrophile, par exemple, où les deux parties cristallines sont alignées à mieux que 1° en rotation et dont le désalignement en flexion ("miscut" en anglais) ne dépasse pas 1°, si les zones "SOI" et les zones d'oxyde déposées intentionnellement sont suffisamment proches les unes des autres, les précipités d'oxyde formés lors de la disparition du film d'oxyde natif à l'une des surfaces vont pouvoir, en fonction du budget thermique (température et temps) migrer vers les zones de couche d'oxyde avoisinantes qui peuvent être considérés ici comme de très gros précipités qui vont attirer les plus petits qui se trouvent dans leur voisinage. La portée de cette attraction dépend non seulement du budget thermique mais aussi de la densité des pièges naturels d'oxydes que sont les dislocations, dont la densité dépend du désalignement. Ce mécanisme est renforcé par la localisation des pièges et des précipités, créés par le scellement à l'interface de collage.

Dans le cas d'un collage hydrophobe il est possible, en adaptant la surface des zones massives (ou "bulk"), de pouvoir obtenir un interface sans précipités, même si on autorise un angle substantiel de désorientation (volontaire ou non) entre les deux cristaux, c'est à dire un angle supérieur au maximum autorisé dans les documents précités pour le collage de deux plaquettes de silicium sans couche d'oxyde enterrée. Cela permet de s'affranchir du contrôle, ou du moins de permettre un contrôle moins précis, des angles de désorientation cristalline lors d'un collage hydrophobe, ce qui a l'avantage de simplifier le procédé de fabrication.

Par ailleurs il peut être intéressant de créer un réseau de dislocations, par exemple pour la croissance de nanostructures. II est donc intéressant lors de la fabrication des zones "bulk" d'imposer un désalignement entre les deux parties cristallines. Par exemple, on peut imposer un désalignement d'environ 6° en rotation et d'environ 1° en flexion. D'après l'article "Growth, Shrinkage..." précité, cet angle de 6° ne permet pas d'obtenir un interface sans précipité d'oxyde. Mais grâce à la présence, selon l'invention, de pièges il devient possible avec un tel désalignement d'obtenir un interface sans précipités.

L'existence même de l'interface de collage est ici avantageuse car, en tant qu'interface, il va permettre une diffusion plus facile des impuretés des zones "bulk" vers les pièges.

II est important de noter que cette attraction n'est pas limitée aux précipités d'oxygène et peut agir sur d'autres contaminants comme le carbone, ou d'autres impuretés présentes à la surface ou près de celle-ci au moment de la mise en contact lors du collage.

D'un point de vue quantitatif, la distance maximale à laquelle toute portion de la zone massive doit se trouver d'un piège est de l'ordre de quelques millimètres.

Une distance de l'ordre du millimètre apparaît appropriée pour la plupart des matériaux dont le silicium.

Comme indiqué ci-dessus, les pièges que l'invention enseigne de mettre en place peuvent être constitués de zones de couche d'oxyde faisant partie des zones SOI, donc situées à proximité des zones "bulk". Aucun autre piège peut n'être nécessaire si la répartition des zones massives et des zones isolées a été prévue en sorte que toute portion de ces zones massives soit à au plus la distance donnée d'une zone isolée, ce qui correspond en pratique à un aménagement spécifique des plaquettes dans la mesure où les zones massives sont, depuis qu'il a été proposé de réaliser des substrats mixtes, généralement très étendues, le plus souvent en partie centrale des plaquettes ; en d'autres termes, si l'on choisit de ne pas ajouter de pièges à l'intérieur de l'interface des zones massives, l'invention implique de modifier la répartition des zones massives et isolées par rapport à ce qui est connu dans les substrats mixtes.

Lorsque la configuration des zones massives et des zones isolées ne satisfait pas à la condition précitée, l'invention enseigne d'ajouter des pièges dans l'interface des zones massives ; on peut noter qu'alors il peut paraître paradoxal d'enseigner de prévoir des défauts dans un interface dont on veut optimiser la qualité ; mais il est apparu que, si les couches d'oxyde présentes à l'intérieur de l'interface des zones massives sont suffisamment petites, elles jouent efficacement leur rôle de pièges sans pour autant gêner la conduction électrique. Par taille suffisamment petite, il faut entendre ici quelques nanomètres carrés.

La localisation des pièges étant connue et précise, on adaptera en conséquence la géométrie des composants au sein des zones massives pour éviter tout problème.

C'est ainsi que, selon des caractéristiques préférées, avantageusement combinées :
- les zones en matériau différent et les pièges sont des couches d'oxyde localisées.
- les pièges et les zones en matériau différent peuvent avoir des épaisseurs différentes et être ou non accolées.
- les couches d'oxyde localisées ont une épaisseur comprise entre quelques nanomètres et quelques millimètres, par exemple entre 0.01 et 3 micron environ.
- les couches d'oxyde localisé ont une forme par exemple rectangulaire dont les dimensions sont comprises entre quelques dixièmes ou centièmes de micron et quelques millimètres (selon qu'elles forment ou non des pièges).
- on prépare les couches d'oxyde localisées par oxydation thermique au travers d'un masque ; en variante on prépare les couches d'oxyde localisées par dépôt au travers d'un masque, ou à l'aide d'une gravure d'une couche d'oxyde.
- la préparation comporte une étape de traitement des faces pour les rendre hydrophobes ; dans ce cas, de préférence, le seuil donné en désalignement est de +-6° en rotation et de +-1° en flexion ; de manière avantageuse on grave l'une des faces avec un masque avec des motifs qui ne sont pas écartés de plus de la distance donnée, on génère ensuite sur cette face une couche d'oxyde (on dépose une couche d'oxyde thermique ou on provoque une couche d'oxyde natif), et on planarise la face jusqu'à dénuder (ou au moins approcher de très près) les zones non gravées, et on nettoie cette face de manière à la rendre hydrophobe.
- la préparation comporte une étape de traitement des faces pour les rendre hydrophiles ; dans ce cas, de préférence, le seuil donné en désalignement est de +-1° ° en rotation et en flexion ; de manière avantageuse on grave l'une des faces présentant une couche d'oxyde en utilisant un masque avec des motifs qui ne sont pas écartés de plus de la distance donnée, on génère sur cette face une couche d'oxyde (oxyde thermique ou natif), et on planarise la face jusqu'à dénuder (ou au moins approcher de très près) des zones non gravées de matériau constitutif de la partie cristalline, et on nettoie cette face de manière à la rendre hydrophile.
- chaque partie cristalline est réalisée en un matériau choisi dans le groupe comportant Si, InP, AsGa, Ge, les composés de silicium dont le silicium-germanium, LiNbO3, les composés III-V, SiC, le diamant, le saphir, les matériaux piézoélectriques ou pyroélectriques ; de préférence, chaque partie cristalline est en silicium, ce qui a l'avantage de mettre en oeuvre des techniques bien connues.
- le traitement thermique dure quelques heures à une température comprise entre 800°C et 1400°C et la distance donnée est de l'ordre du millimètre.
- on traite les faces destinées à former l'interface par désoxydation par du HF, et/ou par traitement thermique, et/ou par polissage mécano-chimique, et/ou par traitement plasma, et/ou par voie chimique.
- on applique un traitement d'amincissement à l'un des substrats ; par exemple, on amincit l'un des substrats par un traitement d'abrasion mécano-chimique ; en variante, on amincit l'un des substrats par réalisation d'une couche fragile et par fracture le long de cette couche fragile (cette couche fragile peut notamment être réalisée par implantation ionique à une profondeur donnée, par exemple par implantation d'ions d'hydrogène). Une autre variante consiste à préparer l'un des substrats en sorte qu'il soit démontable, avec un interface démontable (à niveau de tenue mécanique contrôlé et suffisamment faible pour permettre ledit démontage).

De manière avantageuse, on prépare les deux substrats, ou du moins les deux parties cristallines, en les prélevant dans un même cristal d'origine, par découpe par exemple. Avant découpe, des repères de positionnement sont réalisés de part et d'autre du plan de coupe. On colle ensuite les deux faces créées lors de la découpe en préparant l'interface selon l'invention, et en contrôlant grâce aux repères le positionnement de ces faces.

De manière particulièrement avantageuse, ce prélèvement de deux cristaux s'effectue par création dans le cristal d'origine d'une couche fragile. Les repères de positionnement sont réalisés de part et d'autre de cette couche fragile. On provoque ensuite une fracture le long de cette couche fragile en sorte de créer deux faces libres, et on réalise l'interface, après réalisation des zones électriquement isolantes (si c'est ainsi que doivent être réalisées les zones en matériau différent) et les pièges, par mise en contact de ces faces en mettant en regard lesdits repères.

Cette couche fragile est de préférence formée par implantation ionique (par exemple de l'hydrogène) et les repères sont avantageusement formés dans l'épaisseur du cristal d'origine de part et d'autre de la couche fragile.

Selon un autre aspect, l'invention propose un substrat mixte (ou structure) comportant deux substrats comportant un interface obtenu par collage moléculaire de deux faces, ces substrats comportant des parties cristallines présentant de part et d'autre de l'interface un écart en désalignement inférieur à +-6° en rotation et à +-1° en flexion et comportant à cet interface des zones empilées, comportant au moins une zone localisée essentiellement constituée d'un matériau différent de ceux constitutifs des parties cristallines, et d'éventuels pièges à impuretés tels que toute portion de l'interface à l'écart des zones empilées soit à au plus une distance donnée d'une zone empilée ou d'un piège.

Selon des dispositions préférées, avantageusement combinées, la distance donnée est de l'ordre du millimètre, les cristaux sont en silicium, les pièges sont des couches enterrées, par exemple des couches d'oxyde localisées, et les zones en matériau différent sont des couches d'oxyde localisées, ou des couches électriquement isolantes.

Des objets, caractéristiques et avantages de l'invention ressortent de la description qui suit, donnée à titre d'exemple illustratif non limitatif, en regard des dessins annexés sur lesquels :
- les figures 1 à 4 sont des vues en coupe d'une plaquette en cours de préparation en vue de la fabrication d'un substrat mixte,
- les figures 5 à 7 sont des vues en coupe de ce substrat mixte en cours de fabrication à partir de la plaquette des figures 1 à 4,
- les figures 8 à 11 sont des vues en coupe d'une autre plaquette en cours de préparation en vue de la fabrication d'un second substrat mixte,
- les figures 12 à 14 sont des vues en coupe de ce second substrat mixte en cours de fabrication à partir de la plaquette des figures 8 à 11,
- les figures 15 et 17 sont des vues en coupe de la fabrication de deux plaquettes destinées à la fabrication d'un substrat mixte du type de celui des figures 5 à 7,
- les figures 18 à 24 sont des vues en coupe analogues aux figures 1 à 7 décrivant la préparation des substrats de la figure 17 et la fabrication d'un substrat mixte à partir de ceux-ci,
- les figures 25 à 27 sont des vues en coupe de la fabrication de deux plaquettes destinées à la fabrication d'un substrat mixte du type de celui des figures 12 à 14, et
- les figures 28 à 34 sont des vues en coupe analogues aux figures 8 à 14 décrivant la préparation des substrats de la figure 27 et la fabrication d'un substrat mixte à partir de ceux-ci.

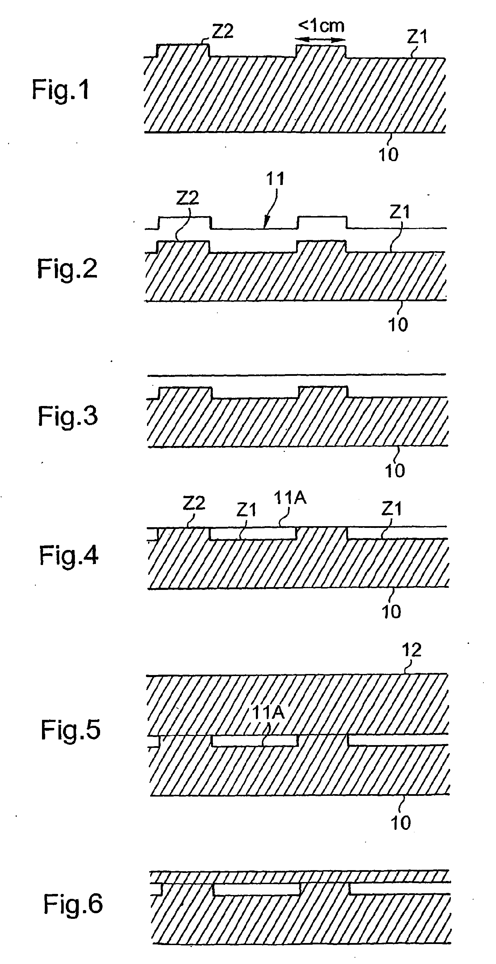

Les figures 1 à 34 représentent plusieurs variantes de réalisation d'un substrat mixte dans lequel des pièges à impuretés sont distribués en sorte d'avoir, dans les zones massives, un interface compatible avec la réalisation de composants de type massif.

Le procédé comporte les étapes suivantes :
- Une première étape consiste à réaliser des zones enterrées, ici isolantes, par exemple en oxyde en silicium, dans une au moins des deux plaquettes de départ, ici en silicium massif. Pour cela, plusieurs approches sont possibles tant pour réaliser l'oxyde que pour le situer avec précision. En ce qui concerne l'oxyde, il peut être soit "natif" (résultant de l'oxydation naturelle de la surface libre des plaquettes), soit obtenu par oxydation de tout ou partie de ces surfaces, soit déposé par tout moyen connu approprié. Quant à sa localisation en des zones bien précises, on connaît un certain nombre de techniques couramment utilisées notamment en micro-électronique. En général, ces techniques sont fondées sur l'utilisation d'un masque lors de l'étape de réalisation de l'oxyde ou sur l'utilisation d'une délimitation effectuée séparément de cette réalisation de l'oxyde. La répartition des zones d'oxyde sur la surface de l'une (ou des deux) faces du futur interface entre les plaquettes est choisie en sorte que ces surfaces ne soient pas trop éloignées les unes des autres au sein de ce futur interface (cette distance étant choisie en fonction des budgets thermiques que les plaquettes auront à subir, et des désalignements qui seront tolérés lors de la réalisation de l'interface.
- Une seconde étape consiste à préparer les surfaces de ces plaquettes, que ce soit physiquement (rugosité...) et/ou chimiquement (nature des liaisons d'espèces de surface...) pour obtenir ultérieurement un bon collage moléculaire. Plusieurs approches sont possibles, avec en particulier des polissages mécano-chimiques (CMP en abrégé pour Chemical Mechanical Polishing), et des procédés de nettoyage chimique permettant d'obtenir des niveaux d'hydrophilie (hydrophobie) différents selon que l'interface sera localement réalisé entre les matériaux de chacune des plaquettes ou avec un oxyde. Cette étape est détaillée plus loin ; elle peut comporter également un traitement UV ozone et/ou plasma.
- Une troisième étape consiste à mettre les faces préparées en contact intime et à provoquer l'adhésion moléculaire des deux plaquettes ; cette mise en contact intime est réalisée en imposant ou en tolérant des désalignements cristallins entre les deux plaquettes.
- Une quatrième étape consiste à effectuer un traitement thermique de consolidation (ou de stabilisation) du collage, lequel favorise également les mécanismes de piégeage.
- Une cinquième étape, fréquente en pratique, consiste à amincir l'une des plaquettes pour n'en laisser qu'un film.

On obtient ainsi un substrat mixte fait d'une alternance de zones massives ("bulk"), de zones isolées (SOI si les plaquettes sont en silicium), et de zones de piégeage, au besoin, cette alternance étant choisie suivant les besoins de l'application et les distances de piégeage à respecter. Comme on le sait la partie résiduelle après amincissement, lorsque celui-ci est obtenu par fracture le long d'une couche enterrée peut servir de substrat de départ pour un nouveau cycle de fabrication d'un substrat, mixte ou non.

Parmi les manières de préparer les surfaces en vue du collage moléculaire, on peut citer :
- Traitement des surfaces avec du HF. Sur la (ou les) surface(s) où alternent des zones oxydes et des zones de matériau brut, on constate que l'effet d'attaque chimique par HF n'est pas le même sur l'oxyde et sur le silicium brut. Cela a pour conséquence que, lors de la mise en contact pour le collage, les zones oxydées auront (avec une zone en regard de matériau nu, sans oxyde) une énergie de collage différente de celles des zones de matériau nu, mais globalement l'énergie de collage est suffisante pour une bonne cohésion de la structure.
- Traitement thermique. Un recuit, par exemple sous atmosphère d'hydrogène, rend les surfaces de silicium et d'oxyde hydrophobes. D'autres gaz peuvent également être utilisés.
- Polissage mécano-chimique. Il peut conduire sélectivement à un état hydrophobe ou hydrophile ; en effet les surfaces de silicium ne "mouillent" pas après polissage alors que les surfaces d'oxyde "mouillent" après un polissage de même nature. On obtient ainsi des zones hydrophiles et des zones hydrophobes sur la même plaquette. Si cette plaquette est ensuite mise en vis-à-vis de zones de même hydrophilie/hydrophobie, on peut alors bénéficier de la bonne énergie de collage des zones hydrophiles pour les parties oxydes et d'un collage hydrophobe pour les parties nues, qui facilite l'élimination des précipités, ce qui permet d'utiliser une surface sans pièges plus importante, ou un désalignement toléré ou imposé plus important, entre les deux cristaux. La plaquette en regard peut en variante être complètement hydrophile ou complètement hydrophobe, mais alors, soit on accepte d'avoir une énergie de collage moins importante sur certaines zones, soit on fait en sorte d'avoir une couche d'oxyde natif à l'interface Si/Si, dont l'élimination sera effectuée grâce à un budget thermique suffisant, et/ou à un désalignement suffisamment faible et/ou à la présence de pièges suffisamment rapprochés. Après polissage mécano-chimique, on peut également utiliser différents nettoyages pour modifier le caractère d'hydrophilie des diverses zones.
- Traitement plasma. Le choix de l'atmosphère (par exemple hors oxygène ou non oxydante) du traitement permet de contrôler les liaisons de surface, évitant ainsi des liaisons pouvant être à l'origine de la formation d'oxydes entre les deux zones de silicium massif ; on utilise par exemple un plasma riche en fluorocarbone.
- Traitement par voie chimique. Un traitement dans une solution chimique à base de H₂SO₄/H₂O₂/... et/ou NH₄OH/H₂O₂... permet de rendre les surfaces de silicium et d'oxyde hydrophiles en laissant un oxyde natif à la surface des zones de silicium. La préparation peut aussi comporter l'utilisation d'un oxyde contenant une certaine concentration d'eau, avec ensuite un traitement de surface rendant l'ensemble de la surface de la plaquette considérée hydrophobe, par exemple un traitement chimique avec du HF et/ou un traitement thermique à basse température (150°C par exemple) restaurant l'hydrophilie sur les parties oxydes préférentiellement aux zones nues.

Les figures 1 à 7 décrivent un premier exemple de réalisation de l'invention.

Une plaquette de silicium 10, de type CZ, de résistivité 14-22 ohm/cm et de diamètre de 100 mm est gravée en utilisant un masque de photolithographie avec des motifs, par exemple rectangulaires, qui ne sont pas écartés l'un de l'autre de plus de 1 cm et dont la profondeur est de l'ordre de 0.4 micron. Ces zones ont par exemple les dimensions suivantes : 1 cm x 1 cm.

Les zones gravées sont notées Z1 et les zones non gravées Z2.

On génère ensuite sur toute la surface un oxyde thermique 11 de 0.9 micron (figure 2) On polit de manière très plane, par CMP (chemical mechanical polishing, voir ci-dessus), cette couche d'une épaisseur inférieure à celle de la couche 11, par exemple 0.7 micron (figure 3). On effectue un retrait précis en contrôlant l'épaisseur pour retirer toute (ou pratiquement toute) l'épaisseur d'oxyde présente au dessus des zones Z2 (il en effet subsister une fine couche d'oxyde qui sera piégée au moment du recuit) ; il subsiste des zones oxyde notées 11A (figure 4). Ce retrait peut être effectué par un traitement humide avec du HF par exemple, ou par un traitement CMP complémentaire et/ou un recuit hydrogène et/ou un traitement RIE. Ensuite toute la surface est nettoyée par un traitement thermique pour la rendre hydrophobe.

Cette plaquette est ensuite collée par adhésion moléculaire sur une autre plaquette de silicium 12 sans oxyde natif et dont la surface est également hydrophobe (figure 5).

On peut lors de ce collage, par exemple, laisser une tolérance de désorientation de +-1° (qui est la précision des méplats sur les plaquettes commerciales de silicium de 100 mm) si les plaquettes ont un "miscut" inférieur à 1°.

Ensuite on effectue un recuit de stabilisation à 1300 °C pendant 3 heures.

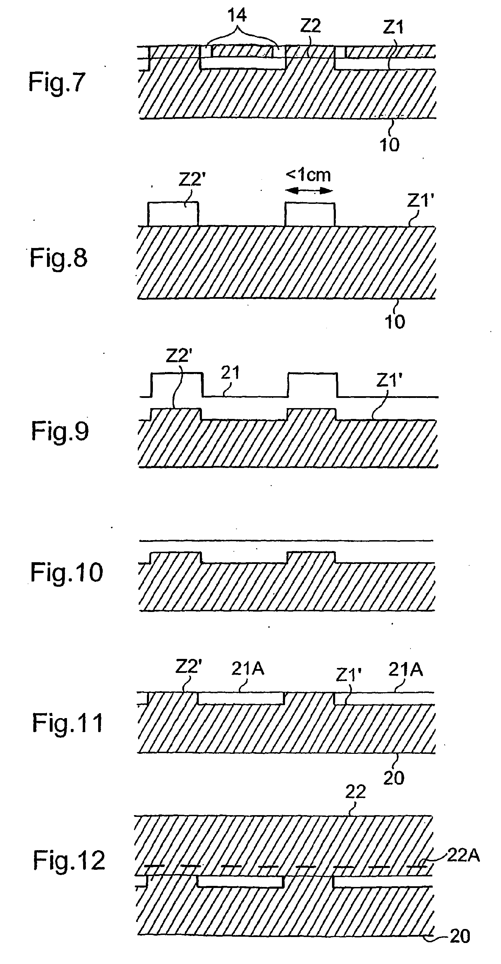

La seconde plaquette est ensuite amincie par une abrasion mécanique et chimique, suivie par un polissage pour obtenir un substrat mixte comportant des zones isolées - SOI - délimitées par les zones Z1 et des zones massives de contact silicium-silicium délimitées par les zones Z2 (figure 6). Ces différentes zones peuvent alors être complètement isolées les unes des autres par des tranchées 14 (figure 7).

Ce substrat mixte est conforme à l'invention en ce sens que les zones isolées (chacune des zones d'oxyde délimite une zone isolée) sont suffisamment proches pour que toute portion des zones d'interface entre ces zones isolées soient à une distance (ici 1 cm) suffisante pour garantir que les impuretés à l'interface entre les zones d'oxyde soient piégées. En variante, seules certaines zones d'oxyde délimitent des zones isolées tandis que les autres sont situées à au niveau de l'interface d'une zone massive (une telle zone d'oxyde ne délimitant pas de zone isolée se reconnaît par exemple par le fait qu'elle n'est pas bordée par des tranchées ; elle peut aussi se caractériser par une taille sensiblement plus petite que celle des zones d'oxyde contribuant à délimiter une zone d'oxyde).

Les figures 8 à 14 représentent un second exemple de réalisation de l'invention.

La plaquette de départ, notée 20, est identique à celle des figures 1 à 7, à ceci près que sa surface est revêtue d'une couche d'oxyde de 1 micron d'épaisseur. Cette plaquette 20 est gravée, en utilisant un masque de photolithographie avec des motifs rectangulaires, jusqu'à enlever complètement cette couche d'oxyde, dans les endroits non masqués. Ces zones gravées sont notées Z1' tandis que les zones non gravées sont notées Z2' (figure 8) ; on peut noter que l'oxyde thermique se forme dans le silicium des zones Z'1 alors qu'il est gêné par le plot d'oxyde au niveau des zones Z'2.

Ces zones gravées ne sont pas séparées de plus de 1 cm.

On réalise ensuite sur toute la surface une couche 21 d'oxyde thermique de 0.8 micron (figure 9) et on planarise ensuite la surface par CMP en enlevant une épaisseur de 1 micron (figure 10).

On effectue un retrait précis en contrôlant l'épaisseur pour retirer toute (ou pratiquement toute) l'épaisseur d'oxyde présente au dessus des zones Z2' (figure 11). Ce retrait peut s'effectuer par un traitement humide avec du HF ou par un traitement CMP additionnel et/ou un recuit hydrogène etou un RIE. Il subsiste des couches localisées 21A

Ensuite, toute la surface est nettoyée par un traitement chimique pour la rendre hydrophile.

Cette plaquette est ensuite collée par adhésion moléculaire sur une autre plaquette de silicium 22 possédant un oxyde natif (non représenté) et dont la surface est également hydrophile. Ce deuxième collage est effectué en minimisant le désalignement entre les deux cristaux, en les orientant par rayons X par exemple.

Cette deuxième plaquette 22 a ici été implantée par des ions hydrogène avec une énergie de 76 KeV et une dose de 5.10¹⁶ at/cm² à travers une couche d'oxyde de 400 nm que l'on a retirée ensuite (figure 12), d'où une couche fragile 22A.

On effectue ensuite un recuit pour provoquer la fracture au niveau de la zone implantée 22A et enfin un recuit de stabilisation du collage à 1300 °C pendant 3 heures.

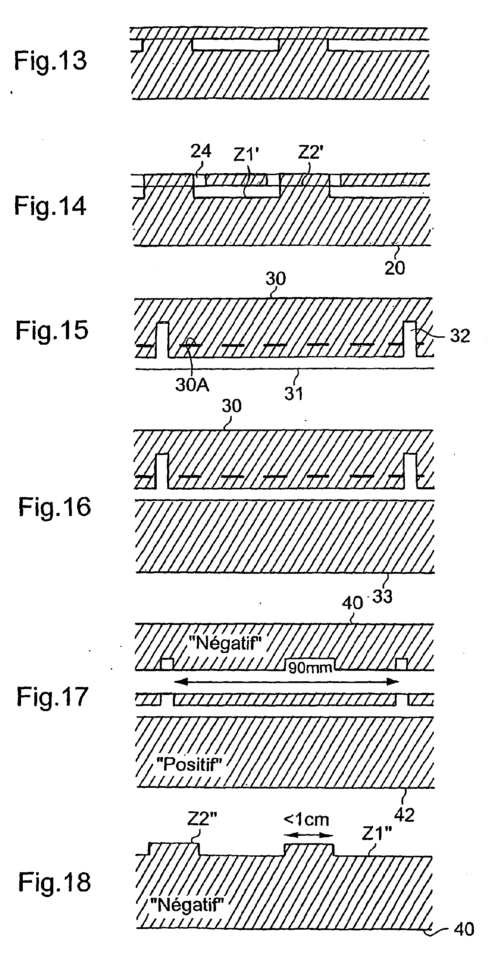

On effectue ensuite un polissage pour obtenir un substrat mixte comportant des zones SOI délimitées par les zones Z1' et des zones "massives" de contact silicium/silicium délimitées par les zones Z2' (figure 13).

Ces zones peuvent alors être isolées les unes des autres par des tranchées 24 (figure 14).

Les figures 15 à 24 représentent un troisième exemple de réalisation présentant des analogies avec le premier exemple de réalisation.

On part d'une plaquette 30 de même composition et de mêmes dimensions que les plaquettes 10 et 20. On l'oxyde pour y former une couche d'oxyde 31 de 400 nm d'épaisseur et on y implante des ions hydrogènes avec une énergie de 76 KeV, avec une dose de 5.10¹⁶ at/cm², formant une couche fragile 30A.

On réalise ensuite par gravure dans cette plaquette des échelles graduées 32 constituées de rectangles de 10 microns x 2 microns, répétés tous les 1/100° sur deux arcs de cercle de 20° positionnés sur un cercle de 90 mm de diamètre (figure 15).

Une deuxième plaquette de silicium 33 de même composition et de mêmes dimensions que précédemment est collée par adhésion moléculaire de type hydrophile sur la première plaquette (figure 16).

On provoque la fracture au niveau de la zone implantée par un traitement mécanique et/ou thermique de tout type connu approprié ; on obtient deux plaquettes 40 et 42 dont l'une de type SOI est appelé dans la suite plaquette "positive" tandis que l'autre est appelée plaquette "négative" (figure 17).

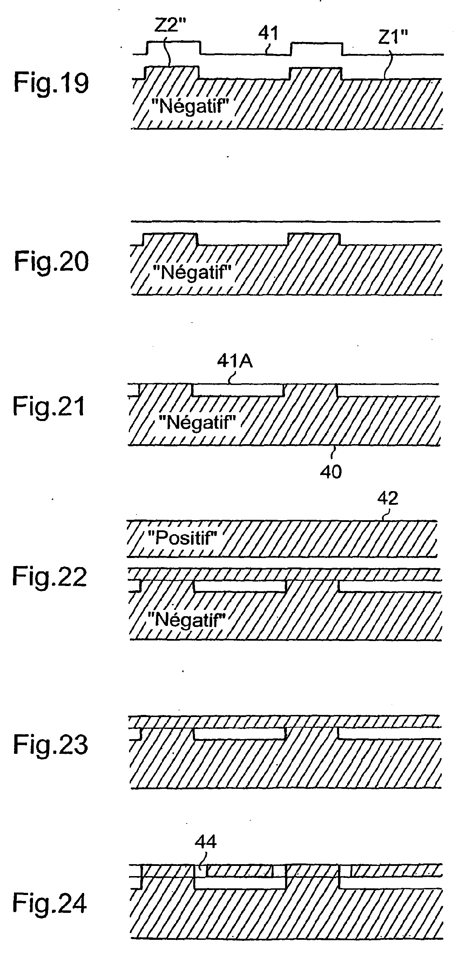

La plaquette 40 subit les mêmes étapes de traitement que la plaquette 10 (les figures 18 à 21 correspondent aux figure 1 à 4) avec génération par dépôt ou oxydation thermique d'une couche d'oxyde 41, jusqu'à l'obtention d'une surface hydrophobe comportant des zones localisées d'oxyde 41A (figure 21).

Cette plaquette est ensuite collée par adhésion moléculaire sur la plaquette 42 positive qui est sans oxyde natif et dont la surface est également hydrophobe (figure 22).

On peut, par exemple, lors de ce collage, aligner les graduations des deux plaquettes afin d'annuler complètement les désorientations de rotation et de flexion entre les deux cristaux collés.

Le fait d'avoir prélevé dans une même plaquette de départ les deux plaquettes devant former le futur interface (au moins dans leurs épaisseurs à proximité de cet interface), et de les aligner selon des repères réalisés avant prélèvement/dissociation garantit un excellent alignement, selon tous les critères, de sorte que la distance minimale pour obtenir une bonne qualité d'interface est fortement augmentée.

Après recuit de stabilisation (1300°C pendant 3 heures) on amincit la plaquette "positive" par abrasion mécanique et chimique en utilisant la couche d'oxyde enterrée de la plaquette "positive" comme couche d'arrêt. On retire ensuite cette couche d'arrêt pour obtenir un subtrat mixte comportant des zones SOI délimitées par les zones Z1" et comportant des zones de contact silicium/silicium délimitées par les zones Z2" (figure 23). Ces différentes zones peuvent être isolées les unes des autres par des tranchées 44 (figure 24).

On notera que les zones de pièges introduites servent à "pomper" les espèces enfermées à l'interface permettant ainsi la reconstruction des zones massives. On évite ainsi dans cet exemple les problèmes inhérents (voir le procédé dit "smart cut" ®) au transfert de film de silicium sur un substrat silicium en collage hydrophobe.

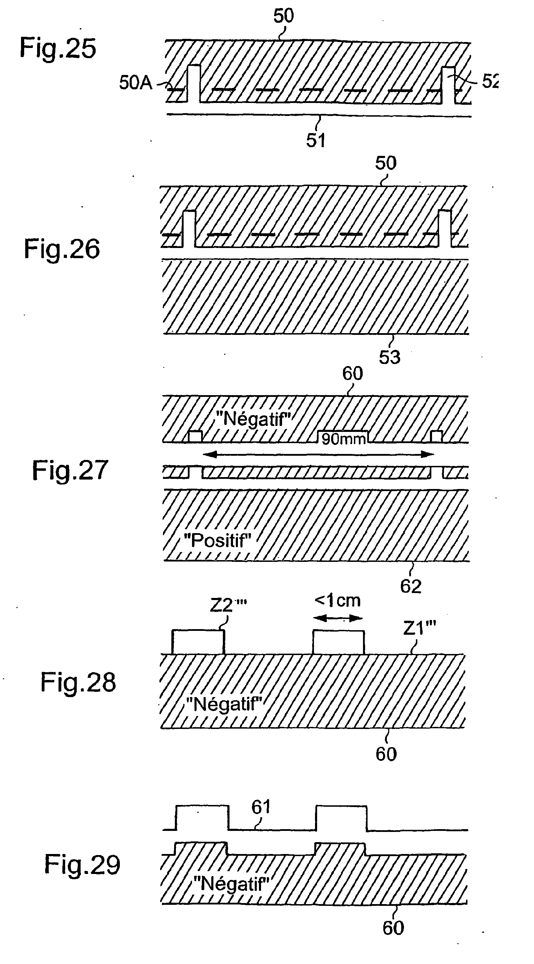

Les figures 25 à 34 représentent un quatrième exemple de réalisation présentant des analogies avec le second mode de réalisation.

Une plaquette 50 de même nature et de mêmes dimensions que les plaquettes précédentes est oxydée pour former une couche d'oxyde 51 de 400 nm et ensuite implantée par des ions hydrogène dans les mêmes conditions que dans le troisième exemple, d'où une couche fragile 50A.

On réalise ensuite le même type de gravure que dans ce troisième exemple pour former des échelles 52 (figure 25).

Une deuxième plaquette 53, de même nature et de mêmes dimensions que les précédentes, est collée par adhésion moléculaire de type hydrophile sur la première plaquette (figure 26) et on provoque la fracture au niveau de la zone implantée comme dans ce troisième exemple, pour obtenir une plaquette 60 appelée "négative" et une plaquette 62 dite "positive" (figure 27).

La plaquette "négative" est ensuite oxydée sur toute sa surface, comme la plaquette 20 du deuxième exemple, pour former une couche d'oxyde d'1 micron d'épaisseur. Cette dernière plaquette est ensuite gravée comme la plaquette 20 (figure 28) et on dépose une couche d'oxyde thermique 61 de 0.8 micron (figure 29). On applique les mêmes traitements que sur la plaquette 20 (les figures 28 à 34 sont analogues aux figures 8 à 14), jusqu'à en rendre la surface hydrophile, avec des zones d'oxyde localisées 61A.

Cette plaquette est ensuite collée sur l'autre plaquette 62, "positive", qui possède un oxyde natif et dont la surface est également hydrophile.

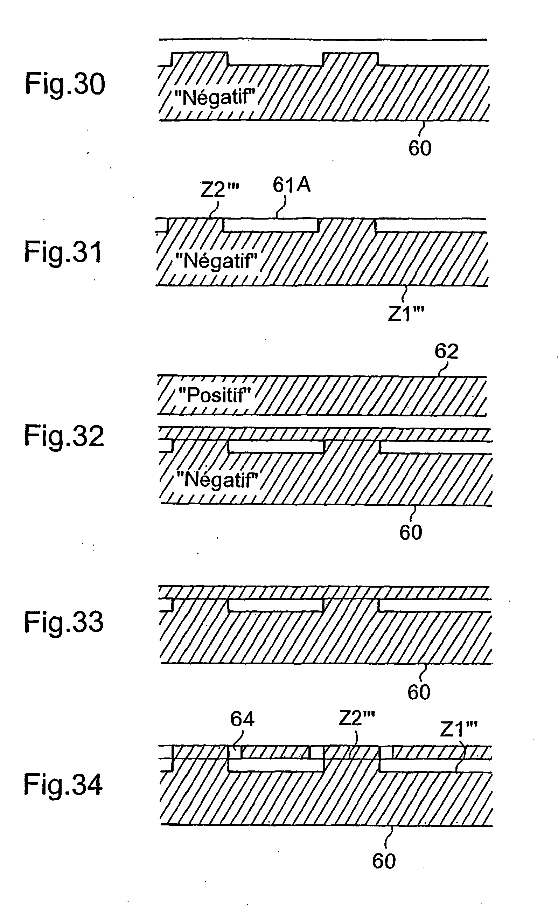

Ce deuxième collage est effectué en minimisant le désalignement entre les deux cristaux en alignant les échelles graduées , comme dans le troisième exemple (figure 32).

On effectue ensuite un recuit pour provoquer la fracture au niveau de la zone implantée et enfin un recuit de stabilisation comme dans le troisième exemple.

La plaquette "positive" est ensuite amincie.

Après enlèvement de la couche d'arrêt, on obtient un substrat mixte comportant des zones SOI délimitées par les zones Z1 "' et des zones "massives" délimitées par les zones Z2"', lesquelles zones peuvent ensuite être isolées les unes par rapport aux autres par des tranchées 64.

Pour la réalisation de composants MEMS ou MOEMS, la couche enterrée de la zone non massive peut ne pas être isolante mais simplement constituée d'un matériau différent du matériau constituant la zone massive. En pratique, c'est souvent le couple silicium/oxyde silicium qui est retenu, mais l'oxyde n'est pas utilisé là pour son caractère isolant. De manière analogue aux exemples précédemment décrits, des pièges sont prévus au niveau de l'interface pour obtenir au niveau des zones massives un interface de bonne qualité (avec un nombre limité d'impuretés).

## Revendications

1. Procédé de fabrication d'un substrat mixte selon lequel :
* on prépare deux substrats présentant des faces respectives destinées à être liées l'une à l'autre et constitués essentiellement au niveau de ces faces de parties cristallines et, pour au moins l'une de ces deux faces, de zones formées d'un matériau différent de ceux constitutifs des parties cristallines,
* on met ces faces en regard et on les relie au niveau d'un interface par collage moléculaire en sorte de former des zones massives dans lesquelles les faces en regard sont essentiellement cristallines et des zones empilées dans lesquelles l'une au moins des faces en regard est essentiellement constituée du matériau différent,
* on effectue un traitement thermique de consolidation du collage,
**caractérisé en ce que**, lors de la préparation des substrats (10, 12 ; 20, 22 ; 40, 42 ; 60, 62) ou lors de la liaison des faces, on crée audit interface des pièges (11A, 21A, 41A, 61A) à impuretés tels que toute portion de cet interface faisant partie d'une zone massive soit à au plus une distance donnée d'un tel piège, tandis que la mise en regard des faces se fait avec un écart en désalignement, entre les parties cristallines de ces deux substrats, inférieur à un seuil donné.

2. Procédé selon la revendication 1, **caractérisé en ce que** les zones formées d'un matériau différent sont des couches électriquement isolantes.

3. Procédé selon la revendication 1 ou la revendication 2, **caractérisé en ce que** les zones formées d'un matériau différent sont des couches d'oxyde localisées.

4. Procédé selon l'une quelconque des revendications 1 à 3, **caractérisé en ce que** les pièges sont des couches enterrées localisées.

5. Procédé selon la revendication 4, **caractérisé en ce que** les pièges sont des couches d'oxyde localisées.

6. Procédé selon l'une quelconque des revendications 3 à 5, **caractérisé en ce que** ces couches ont une épaisseur comprise entre 0.01 et 3 microns environ.

7. Procédé selon l'une quelconque des revendications 3, 5 ou 6, **caractérisé en ce qu'**on prépare les couches d'oxyde localisées par oxydation thermique au travers d'un masque.

8. Procédé selon l'une quelconque des revendications 3, 5 ou 6, **caractérisé en ce qu'**on prépare les couches d'oxyde localisées par dépôt au travers d'un masque.

9. Procédé selon l'une quelconque des revendications 1 à 8, **caractérisé en ce que** la préparation comporte une étape de traitement des faces pour les rendre hydrophobes.

10. Procédé selon la revendication 9, **caractérisé en ce que** le seuil donné en désalignement est de +-6° en rotation et de +-1° en flexion.

11. Procédé selon la revendication 9 ou la revendication 10, **caractérisé en ce que** on grave l'une des faces avec un masque avec des motifs qui ne sont pas écartés de plus de la distance donnée, on génère ensuite sur cette face une couche d'oxyde (11, 41), et on planarise la face jusqu'à dénuder les zones non gravées (Z2, Z2"), et on nettoie cette face de manière à la rendre hydrophobe.

12. Procédé selon l'une quelconque des revendications 1 à 8, **caractérisé en ce que** la préparation comporte une étape de traitement des faces pour les rendre hydrophiles.

13. Procédé selon la revendication 12, **caractérisé en ce que** le seuil donné en désalignement est de +-1° en rotation et en flexion.

14. Procédé selon la revendication 12 ou la revendication 13, **caractérisé en ce que** on grave l'une des faces présentant une couche d'oxyde en utilisant un masque avec des motifs qui ne sont pas écartés de plus de la distance donnée, on génère sur cette face une couche d'oxyde thermique (21, 61), et on planarise la face jusqu'à dénuder des zones non gravées (Z2', Z2"'), et on nettoie cette face de manière à la rendre hydrophile.

15. Procédé selon l'une quelconque des revendications 1 à 14 **caractérisé en ce que** chaque partie cristalline est réalisée en un matériau choisi dans le groupe comportant Si, InP, AsGa, Ge, les composés du silicium, le silicium-germanium, LiNb03, les composés III-V, SiC, le diamant, le saphir, les matériaux piézoélectriques, les matériaux pyroélectriques.

16. Procédé selon l'une quelconque des revendications 1 à 14, **caractérisé en ce que** chaque partie cristalline est en silicium.

17. Procédé selon l'une quelconque des revendications 1 à 16, **caractérisé en ce que** le traitement thermique dure quelques heures à une température comprise entre 800°C et 1400°C et la distance donnée est de l'ordre du millimètre.

18. Procédé selon l'une quelconque des revendications 1 à 17, **caractérisé en ce qu'**on traite les faces destinées à former l'interface par désoxydation par du HF.

19. Procédé selon l'une quelconque des revendications 1 à 18, **caractérisé en ce qu'**on traite les faces destinées à former l'interface par traitement thermique.

20. Procédé selon l'une quelconque des revendications 1 à 19, **caractérisé en ce qu'**on traite les faces destinées à former l'interface par polissage mécano-chimique.

21. Procédé selon l'une quelconque des revendications 1 à 20, **caractérisé en ce qu'**on traite les faces destinées à former l'interface par traitement plasma.

22. Procédé selon l'une quelconque des revendications 1 à 21, **caractérisé en ce qu'**on traite les faces destinées à former l'interface par traitement par voie chimique.

23. Procédé selon l'une quelconque des revendications 1 à 22, **caractérisé en ce que** l'on applique un traitement d'amincissement à l'un des substrats.

24. Procédé selon la revendication 23, **caractérisé en ce que** l'on amincit l'un des substrats par un traitement d'abrasion mécano-chimique.

25. Procédé selon la revendication 23, **caractérisé en ce que** l'un des substrats a été préparé en sorte d'être démontable, et une étape ultérieure consiste à démonter ce substrat.

26. Procédé selon la revendication 23, **caractérisé en ce que** on amincit l'un des substrats par réalisation d'une couche fragile (22A) et par fracture le long de cette couche fragile.

27. Procédé selon l'une quelconque des revendications 1 à 26, **caractérisé en ce que** l'on prépare les parties cristallines des deux substrats à partir d'un même cristal.

28. Procédé selon la revendication 27, **caractérisé en ce que** on prépare les deux substrats en réalisant dans un même cristal d'origine (30, 50) une couche fragile (30A, 50A) et des repères de positionnement (32, 52) situés de part et d'autre de cette couche fragile et en provoquant une fracture le long de cette couche fragile en sorte de créer deux faces libres, et on réalise l'interface avec les zones empilées et les pièges, par mise en contact de ces faces en mettant en regard lesdits repères.

29. Procédé selon la revendication 28, **caractérisé en ce que** cette couche fragile (30A, 50A) est formée par implantation ionique.

30. Procédé selon la revendication 29, **caractérisé en ce que** cette couche fragile est formée par implantation d'ions hydrogène.

31. Procédé selon l'une quelconque des revendications 28 à 30, **caractérisé en ce que** les repères sont formés dans l'épaisseur du cristal d'origine de part et d'autre de la couche fragile.

32. Structure comportant deux substrats comportant un interface obtenu par collage moléculaire de deux faces, ces substrats comportant des parties cristallines présentant de part et d'autre de l'interface un écart en désalignement inférieur à +-6° en rotation et à +-1° en flexion et comportant à cet interface des zones empilées, comportant au moins une zone localisée essentiellement constituée d'un matériau différent de ceux constitutifs des parties cristallines, et d'éventuels pièges à impuretés tels que toute portion de l'interface à l'écart des zones empilées soit à au plus une distance donnée d'une zone empilée ou d'un piège.

33. Structure selon la revendication 32, **caractérisé en ce que** la distance donnée est de l'ordre du millimètre.

34. Structure selon la revendication 32 ou la revendication 33, **caractérisée en ce que** les cristaux sont en silicium.

35. Structure selon l'une quelconque des revendications 32 à 34, **caractérisée en ce que** les pièges sont des couches enterrées localisées.

36. Structure selon la revendication 35, **caractérisée en ce que** les pièges sont des couches d'oxyde localisées.

37. Structure selon l'une quelconque des revendications 32 à 36, **caractérisée en ce que** les zones essentiellement constituées d'un matériau différent sont des zones électriquement isolantes.

38. Structure selon l'une quelconque des revendications 32 à 37, **caractérisée en ce que** les zones essentiellement constituées d'un matériau différent sont des couches d'oxydes localisées.

## Claims

1. Method of fabricating a mixed substrate wherein:
* two substrates are prepared having respective faces adapted to be bonded together and consisting essentially at these faces of crystalline portions and, on at least one of these two faces, of regions formed of a material different from those constituting the crystalline portions,
* these faces are offered up face-to-face and are joined at an interface by molecular bonding to form bulk regions, in which the facing faces are essentially crystalline, and stacked regions, in which at least one of the facing faces essentially consists of the different material, and
* heat treatment is effected to consolidate the bonding,
**characterised in that**, during the preparation of the substrates (10, 12; 20, 22; 40, 42; 60, 62) or during the joining of the faces, impurity traps (11A, 21A, 41A, 61A) are created at said interface such that any portion of that interface forming part of a bulk region is at most at a given distance from a trap, while the faces are offered up face-to-face with a misalignment between the crystalline portions of these two substrates below a given threshold.

2. Method according to claim 1, **characterised in that** the regions formed of a different material are electrically insulative layers.

3. Method according to claim 1 or claim 2, **characterised in that** the regions formed of a different material are localised oxide layers.

4. Method according to any one of claims 1 to 3, **characterised in that** the traps are localised buried layers.

5. Method according to claim 4, **characterised in that** the traps are localised oxide layers.

6. Method according to any one of claims 3 to 5, **characterised in that** these layers have a thickness from approximately 0.01 microns to approximately 3 microns.

7. Method according to any one of claims 3, 5 and 6, **characterised in that** the localised oxide layers are prepared by thermal oxidation through a mask.

8. Method according to any one of claims 3, 5 and 6, **characterised in that** the localised oxide layers are prepared by deposition through a mask.

9. Method according to any one of claims 1 to 8, **characterised in that** preparation includes a step of treating the faces to render them hydrophobic.

10. Method according to claim 9, **characterised in that** the given misalignment threshold is ± 6° in rotation and ± 1° in bending.

11. Method according to claim 9 or claim 10, **characterised in that** one of the faces is etched using a mask with patterns that are not farther apart than the given distance, an oxide layer (11, 41) is then generated on this face, the face is planarised to expose the non-etched regions (Z2, Z2") and this face is cleaned to render it hydrophobic.

12. Method according to any one of claims 1 to 8, **characterised in that** preparation includes a step of treating the faces to render them hydrophilic.

13. Method according to claim 12, **characterised in that** the given misalignment threshold is ± 1° in rotation and in bending.

14. Method according to claim 12 or claim 13, **characterised in that** one of the faces with an oxide layer is etched using a mask with patterns that are not farther apart than the given distance, a thermal oxide layer (21, 61) is generated on this face, the face is planarised to expose the non-etched regions (Z2', Z2"') and this face is cleaned to render it hydrophilic.

15. Method according to any one of claims 1 to 14, **characterised in that** each crystalline portion is made from a material selected from the group comprising Si, InP, AsGa, Ge, compounds of silicon, silicon-germanium, LiNbO₃, III-V compounds, SiC, diamond, sapphire, piezoelectric materials, pyroelectric materials.

16. Method according to any one of claims 1 to 14, **characterised in that** each crystalline portion is of silicon.

17. Method according to any one of claims 1 to 16, **characterised in that** the heat treatment lasts a few hours at a temperature from 800°C to 1400°C and the given distance is of the order of one millimetre.

18. Method according to any one of claims 1 to 17, **characterised in that** the faces adapted to form the interface are treated by deoxidation with HF.

19. Method according to any one of claims 1 to 18, **characterised in that** the faces adapted to form the interface are heat treated.

20. Method according to any one of claims 1 to 19, **characterised in that** the faces adapted to form the interface are treated by chemical mechanical polishing.

21. Method according to any one of claims 1 to 20, **characterised in that** the faces adapted to form the interface are plasma treated.

22. Method according to any one of claims 1 to 21, **characterised in that** the faces adapted to form the interface are chemically treated.

23. Method according to any one of claims 1 to 22, **characterised in that** a thinning treatment is applied to one of the substrates.

24. Method according to claim 23, **characterised in that** one of the substrates is thinned by a chemical mechanical abrasion treatment.

25. Method according to claim 23, **characterised in that** one of the substrates is prepared so that it is demountable and a subsequent step consists in demounting this substrate.

26. Method according to claim 23, **characterised in that** one of the substrates is thinned by producing a fragile layer (22A) and by fracturing this fragile layer.

27. Method according to any one of claims 1 to 26, **characterised in that** the crystalline portions of the two substrates are prepared from the same crystal.

28. Method according to claim 27, **characterised in that** the two substrates are prepared by producing a fragile layer (30A, 50A) in the same source crystal (30, 50), placing markers (32, 52) on either side of this fragile layer and causing a fracture in this fragile layer to create two free faces, and the interface with the stacked regions and the traps is made by bringing these faces into contact after lining up said markers.

29. Method according to claim 28, **characterised in that** this fragile layer (30A, 50A) is formed by ionic implantation.

30. Method according to claim 29, **characterised in that** this fragile layer is formed by implanting hydrogen ions.

31. Method according to any one of claims 28 to 30, **characterised in that** the markers are formed within the thickness of the source crystal and on either side of the fragile layer.

32. Structure including two substrates including an interface obtained by molecular bonding of two faces, these substrates including crystalline portions having on either side of the interface a misalignment less than ± 6° in rotation and less than ± 1° in bending and including at this interface stacked regions, including at least one localised region essentially consisting of a material different from those constituting the crystalline portions, and where applicable impurity traps such that any portion of the interface away from the stacked regions is at most at a given distance from a stacked region or a trap.

33. Structure according to claim 32, **characterised in that** the given distance is of the order of one millimetre.

34. Structure according to claim 32 or claim 33, **characterised in that** the crystals are of silicon.

35. Structure according to any one of claims 32 to 34, **characterised in that** the traps are localised buried layers.

36. Structure according to claim 35, **characterised in that** the traps are localised oxide layers.

37. Structure according to any one of claims 32 to 36, **characterised in that** the regions essentially consisting of a different material are electrically insulative regions.

38. Structure according to any one of claims 32 to 37, **characterised in that** the regions essentially consisting of a different material are localised oxide layers.

## Patentansprüche

1. Verfahren zur Herstellung eines gemischten Substrats, bei dem:
* man zwei Substrate herstellt, die jeweilige Seiten aufweisen, die dazu bestimmt sind, miteinander verbunden zu werden, und im Wesentlichen auf Höhe dieser Seiten aus kristallinen Teilen und, bei mindestens einer dieser beiden Seiten, aus Zonen bestehen, die aus einem anderen Werkstoff als denjenigen, die die kristallinen Teile bilden, gebildet sind,
* man diese Seiten einander gegenüberbringt und sie auf Höhe einer Trennfläche durch molekulare Verklebung verbindet, so dass massive Zonen, in denen die einander gegenüberstehenden Seiten im Wesentlichen kristallin sind, und geschichtete Zonen gebildet werden, in denen mindestens eine der einander gegenüberstehenden Seiten im Wesentlichen aus dem anderen Werkstoff besteht,
* man eine Wärmebehandlung zur Verfestigung der Verklebung durchführt,
**dadurch gekennzeichnet, dass** man bei der Herstellung der Substrate (10, 12; 20, 22; 40, 42; 60, 62) oder bei der Verbindung der Seiten an dieser Trennfläche solche Verunreinigungsfallen (11A, 21A, 41A, 61A) erzeugt, dass der gesamte Abschnitt dieser Trennfläche, der Teil einer massiven Zone bildet, höchstens in einem gegebenen Abstand von einer solchen Falle ist, während das Einandergegenüber-Bringen der Seiten mit einer Fluchtabweichung zwischen den kristallinen Teilen dieser beiden Substrate stattfindet, die kleiner als eine gegebene Schwelle ist.

2. Verfahren nach Anspruch 1, **dadurch gekennzeichnet, dass** die aus einem anderen Werkstoff gebildeten Zonen elektrisch isolierende Schichten sind.

3. Verfahren nach Anspruch 1 oder Anspruch 2, **dadurch gekennzeichnet, dass** die von einem anderen Werkstoff gebildeten Zonen lokalisierte Oxidschichten sind.

4. Verfahren nach einem der Ansprüche 1 bis 3, **dadurch gekennzeichnet, dass** die Fallen lokalisierte vergrabene Schichten sind.

5. Verfahren nach Anspruch 4, **dadurch gekennzeichnet, dass** die Fallen lokalisierte Oxidschichten sind.

6. Verfahren nach einem der Ansprüche 3 bis 5, **dadurch gekennzeichnet, dass** diese Schichten eine Dicke zwischen etwa 0,01 und 3 Mikron haben.

7. Verfahren nach einem der Ansprüche 3, 5 oder 6, **dadurch gekennzeichnet, dass** man die lokalisierten Oxidschichten durch thermische Oxidation über eine Maske herstellt.

8. Verfahren nach einem der Ansprüche 3, 5 oder 6, **dadurch gekennzeichnet, dass** man die lokalisierten Oxidschichten durch Auftrag durch eine Maske herstellt.

9. Verfahren nach einem der Ansprüche 1 bis 8, **dadurch gekennzeichnet, dass** die Herstellung einen Schritt der Behandlung der Seiten umfasst, um sie hydrophob zu machen.

10. Verfahren nach Anspruch 9, **dadurch gekennzeichnet, dass** die gegebene Schwelle der Fluchtabweichung +-6° in Drehung und +-1° in Biegung beträgt.

11. Verfahren nach Anspruch 9 oder Anspruch 10, **dadurch gekennzeichnet, dass** man eine der Seiten mit einer Maske mit Motiven graviert, die nicht mehr als um den gegebenen Abstand voneinander entfernt sind, man dann auf dieser Seite eine Oxidschicht (11, 41) erzeugt und man die Seite planarisiert, bis die nicht gravierten Zonen (Z2, Z2") blank liegen, und man diese Seite so reinigt, dass sie hydrophob gemacht wird.

12. Verfahren nach einem der Ansprüche 1 bis 8, **dadurch gekennzeichnet, dass** die Herstellung einen Schritt der Behandlung der Seiten umfasst, um sie hydrophil zu machen.

13. Verfahren nach Anspruch 12, **dadurch gekennzeichnet, dass** die gegebene Schwelle der Fluchtabweichung +-1° in Drehung und in Biegung beträgt.

14. Verfahren nach Anspruch 12 oder Anspruch 13, **dadurch gekennzeichnet, dass** man eine der Seiten, die eine Oxidschicht aufweist, graviert, indem man eine Maske mit Motiven verwendet, die nicht um mehr als den gegebenen Abstand voneinander entfernt sind, man auf dieser Seite eine thermische Oxidschicht (21, 61) erzeugt und man die Seite planarisiert, bis nicht gravierte Zonen (Z2', Z2"') blank liegen, und man diese Seite so reinigt, dass sie hydrophil gemacht wird.

15. Verfahren nach einem der Ansprüche 1 bis 14, **dadurch gekennzeichnet, dass** jeder kristalline Teil aus einem Werkstoff hergestellt wird, der aus der Gruppe ausgewählt ist, die Si, InP, AsGa, Ge, die Siliziumverbindungen, Silizium-Germanium, LiNb03, die III-V-Verbindungen, SiC, Diamant, Saphir, piezoelektrische Werkstoffe, pyroelektrische Werkstoffe umfasst.

16. Verfahren nach einem der Ansprüche 1 bis 14, **dadurch gekennzeichnet, dass** jeder kristalline Teil aus Silizium besteht.

17. Verfahren nach einem der Ansprüche 1 bis 16, **dadurch gekennzeichnet, dass** die thermische Behandlung einige Stunden bei einer Temperatur zwischen 800°C und 1400°C dauert und der gegebene Abstand etwa einen Millimeter beträgt.

18. Verfahren nach einem der Ansprüche 1 bis 17, **dadurch gekennzeichnet, dass** man die Seiten, die dazu bestimmt sind, die Trennfläche zu bilden, durch Desoxidation durch HF behandelt.

19. Verfahren nach einem der Ansprüche 1 bis 18, **dadurch gekennzeichnet, dass** man die Seiten, die dazu bestimmt sind, die Trennfläche zu bilden, durch Wärmebehandlung behandelt.

20. Verfahren nach einem der Ansprüche 1 bis 19, **dadurch gekennzeichnet, dass** man die Seiten, die dazu bestimmt sind, die Trennfläche zu bilden, durch mechanochemische Polierung behandelt.

21. Verfahren nach einem der Ansprüche 1 bis 20, **dadurch gekennzeichnet, dass** man die Seiten, die dazu bestimmt sind, die Trennfläche zu bilden, durch Plasmabehandlung behandelt.

22. Verfahren nach einem der Ansprüche 1 bis 21, **dadurch gekennzeichnet, dass** man die Seiten, die dazu bestimmt sind, die Trennfläche zu bilden, durch Behandeln auf chemischem Weg behandelt.

23. Verfahren nach einem der Ansprüche 1 bis 22, **dadurch gekennzeichnet, dass** man an einem der Substrate eine Verdünnungsbehandlung vornimmt.

24. Verfahren nach Anspruch 23, **dadurch gekennzeichnet, dass** man eines der Substrate durch eine mechanochemische Abriebbehandlung verdünnt.

25. Verfahren nach Anspruch 23, **dadurch gekennzeichnet, dass** eines der Substrate so hergestellt wurde, dass es demontierbar ist, und ein nachfolgender Schritt darin besteht, dieses Substrat zu demontieren.

26. Verfahren nach Anspruch 23, **dadurch gekennzeichnet, dass** man eines der Substrate durch Herstellen einer zerbrechlichen Schicht (22A) und durch Brechen längs dieser zerbrechlichen Schicht verdünnt.

27. Verfahren nach einem der Ansprüche 1 bis 26, **dadurch gekennzeichnet, dass** man die kristallinen Teile der beiden Substrate aus ein und demselben Kristall herstellt.

28. Verfahren nach Anspruch 27, **dadurch gekennzeichnet, dass** man die beiden Substrate herstellt, indem man in ein und demselben Ursprungskristall (30, 50) eine zerbrechliche Schicht (30A, 50A) und Positionsmarken (32, 52) herstellt, die zu beiden Seiten dieser zerbrechlichen Schicht gelegen sind, und indem man einen Bruch längs dieser zerbrechlichen Schicht bewirkt, so dass zwei freie Seiten geschaffen werden, und man die Trennfläche mit den geschichteten Zonen und den Fallen durch In-Kontakt-Bringen dieser Seiten herstellt, indem diese Marken einander gegenüber gebracht werden.

29. Verfahren nach Anspruch 28, **dadurch gekennzeichnet, dass** diese zerbrechliche Schicht (30A, 50A) durch Ionenimplantation gebildet wird.

30. Verfahren nach Anspruch 29, **dadurch gekennzeichnet, dass** diese zerbrechliche Schicht durch Wasserstoffionenimplantation gebildet wird.

31. Verfahren nach einem der Ansprüche 28 bis 30, **dadurch gekennzeichnet, dass** die Marken in der Dicke des Ursprungskristalls zu beiden Seiten der zerbrechlichen Schicht gebildet werden.

32. Struktur, umfassend zwei Substrate, umfassend eine durch molekulare Verklebung von zwei Seiten erhaltene Trennfläche, wobei diese Substrate kristalline Teile umfassen, die zu beiden Seiten der Trennfläche eine Fluchtabweichung von weniger als +-6° in Drehung und +-1° in Biegung aufweisen, und umfassend an dieser Trennfläche geschichtete Zonen, die mindestens eine örtliche Zone umfassen, die im Wesentlichen aus einem Werkstoff, der von denjenigen, die die kristallinen Teile bilden, verschieden ist, und aus eventuellen solchen Verunreinigungsfallen besteht, dass jeder Abschnitt der Trennfläche in einem Abstand von den geschichteten Zonen sich höchstens in einem gegebenen Abstand von einer geschichteten Zone oder einer Falle befindet.

33. Struktur nach Anspruch 32, **dadurch gekennzeichnet, dass** der gegebene Abstand etwa einen Millimeter beträgt.

34. Struktur nach Anspruch 32 oder Anspruch 33, **dadurch gekennzeichnet, dass** die Kristalle aus Silizium bestehen.

35. Struktur nach einem der Ansprüche 32 bis 34, **dadurch gekennzeichnet, dass** die Fallen lokalisierte vergrabene Schichten sind.

36. Struktur nach Anspruch 35, **dadurch gekennzeichnet, dass** die Fallen lokalisierte Oxidschichten sind.

37. Struktur nach einem der Ansprüche 32 bis 36, **dadurch gekennzeichnet, dass** die im Wesentlichen aus einem anderen Werkstoff bestehenden Zonen elektrisch isolierende Zonen sind.

38. Struktur nach einem der Ansprüche 32 bis 37, **dadurch gekennzeichnet, dass** die im Wesentlichen aus einem anderen Werkstoff bestehenden Zonen lokalisierte Oxidschichten sind.
